# EUROPÄISCHE PATENTSCHRIFT

(11) **EP 3 971 590 B1**
(45) Veröffentlichungstag und Bekanntmachung des Hinweises auf die Patenterteilung: **22.02.2023**
(21) Anmeldenummer: 21192977.3
(22) Anmeldetag: 25.08.2021
(51) Int. Cl.: G01R 27/18, G01R 31/52

(54) **ELEKTRISCHE MESSANORDNUNG UND VERFAHREN ZUR KONTINUIERLICHEN ÜBERWACHUNG EINES SCHUTZLEITERWIDERSTANDS**
ELECTRICAL MEASURING ARRANGEMENT AND METHOD FOR CONTINUOUSLY MONITORING A PROTECTIVE CIRCUIT RESISTANCE
AGENCEMENT ÉLECTRIQUE DE MESURE ET PROCÉDÉ DE SURVEILLANCE CONTINUE D'UNE RÉSISTANCE DE CONDUCTEUR DE PROTECTION

(30) Priorität: 16.09.2020 DE 102020124143
(43) Veröffentlichungstag der Anmeldung: 23.03.2022
(73) Patentinhaber: Bender GmbH & Co. KG, 35305 Grünberg (DE)
(72) Erfinder: BRÖCKMANN, Eckhard, 35396 Gießen (DE); HACKL, Dieter, 35463 Fernwald (DE)
(74) Vertreter: advotec.

(56) Entgegenhaltungen:
- DE-A1-102012 019 094
- DE-A1-102013 209 142
- DE-B3-102016 202 021

## Beschreibung

Die Erfindung betrifft eine elektrische Messanordnung und ein Verfahren zur kontinuierlichen Überwachung eines Schutzleiterwiderstands einer Schutzleiterverbindung in einem Stromversorgungssystem mit einer Versorgungsstation, welche erste Ableitkondensatoren aufweist, mit einer Versorgungsleitung, welche aktive Leiter aufweist, und mit einer über die Schutzleiterverbindung geerdeten elektrischen Einrichtung, welche zweite Ableitkondensatoren und einen Verbraucher aufweist.

Im Rahmen der für elektrische Anlagen vorgeschriebenen Schutzmaßnahme "automatische Abschaltung der Stromversorgung" ist ein genügend hoher Stromfluss in dem zu überwachenden Anlagenteil die Voraussetzung dafür, dass installierte Überstromschutzeinrichtungen schnell genug auslösen können. Bei einem geerdeten Stromversorgungssystem (TN-System, TN-Netz) gilt dies im Falle des ersten Fehlers, bei einem ungeerdeten Stromversorgungssystem (IT-System, IT-Netz) im Falle des zweiten Fehlers. Es muss somit gewährleistet sein, dass die Impedanz (Schleifenimpedanz) einer von der Versorgungsstation über die aktiven Leiter einer Versorgungsleitung zu dem Verbraucher und zurück über die Schutzleiterverbindung gebildeten Stromschleife niederohmig ist, um einen hinreichend hohen Schleifenstrom als Auslösestrom zu bewirken.

In der Norm IEC61557-3: 2007 werden daher spezielle Anforderungen an Messgeräte zum Messen der Schleifenimpedanz festgelegt, wobei die Messung mittels Netzspannungsabsenkung durch Belastung des Netzes erfolgt. In der praktischen Anwendung erscheint diese Messmethode jedoch nur für eine zyklische Überprüfung und nicht für eine kontinuierliche Überwachung des Schleifenwiederstands im aktiven Betrieb geeignet. Insbesondere ist diese Messmethode nicht für IT-Systeme anwendbar, da in IT-Systemen zur Messung der Schleifenimpedanz bereits ein Fehler mit vernachlässigbarer Impedanz an einem aktiven Leiter gegen Erde geschaltet werden muss, um die beschriebene Messschleife auszubilden. Bei einem ersten Fehler mit vernachlässigbarer Impedanz werden jedoch auch vorhandene Netzableitkapazitäten schlagartig entladen. Dies kann in weitläufigen IT-Netzen mit dementsprechend großen Netzableitkapazitäten zur Lichtbögen und hohen Ableitströmen führen. Damit ist eine Bestimmung der Schleifenimpedanz in einem IT-System mittels des Schleifenstroms nicht ungefährlich und bedeutet eine zusätzliche Belastung für die elektrische Anlage.

Aus dem Stand der Technik sind daher weitere Vorrichtungen zur Schleifenmessung mit Einspeisung eines Messsignals bekannt, die mit einer Pilotleitung - auch Steuer- oder Prüfleitung genannt - als Messstromrückleitung ausgestattet sind.

Die Pilotleitung wird auf der Seite des Verbrauchers mit dem Schutzleiter verbunden. Somit kann mit einer einfachen Widerstandsmessung in der Versorgungsstation der Schleifenwiderstand der Pilotleitung und der Schutzleiterverbindung inklusive der Kontaktwiderstände einer Steckverbindung ermittelt werden.

Beispielsweise wird in der DE 10 2017 213 357 B3 ein Verfahren mit einer pulsierenden Aufschaltung eines Messsignals auf die Steuerleitung beschrieben. Wird entweder die Steuerleitung oder die Schutzleiterverbindung oder werden beide durch einen Defekt hochohmig, kann dieser Fehler leicht erkannt werden.

Die Notwendigkeit der Pilotleitung bedeutet aber einen Nachteil, da nur spezielle Versorgungsleitungen verwendet werden können, die eine Pilotleitung enthalten. Es besteht nachträglich keine Möglichkeit der Überwachung, wenn bereits vorhandene Versorgungsleitungen ohne Pilotleitung weiter verwendet werden sollen.

Andere Vorschläge aus dem Stand der Technik beruhen auf natürlich vorhandenen Mehrfacherdungen oder auf bewusst geschaffenen Mehrfacherdungen in der Funktion eines Pilotleiters.

So wird in der Offenlegungsschrift DE 10 2015 218 764 A1 ein Verfahren für den Landanschluss von Schiffen in Häfen beschrieben, bei dem induktiv ein Messsignal in die Schutzleiterverbindung einkoppelt wird. Zur Bildung einer Stromschleife wird das Vorhandensein von Mehrfacherdungen über elektrisch leitfähiges Salzwasser oder eine metallische Landungsbrücke ausgenutzt. Die Bestimmung der Schleifenimpedanz und damit des Schutzleiterwiderstands wird jedoch erschwert, da die Messstromrückführung über die Landungsbrücke ausfallen kann, wenn diese auf isolierten Boden aufgesetzt wird. Zudem ist der elektrische Widerstand der Messstromrückführung über elektrisch leitfähiges Salzwasser nur schwer und nur ungenau zu ermitteln.

In der Offenlegungsschrift US 2013/0191059 A1 wird ebenfalls ein Verfahren beschrieben, welches induktiv ein Messsignal mit einer Frequenz von ca. 2 kHz in die Schutzleiterverbindung einkoppelt. Die Rückleitung des eingeprägten Messsignals erfolgt über das Erdreich, dessen Widerstand als sehr niederohmig und überwiegend ohmsch zu betrachten ist. Messtechnisch betrachtet entspricht damit das Erdreich als Messstromrückleitung einem natürlich vorhandenen Pilotleiter verbunden mit den Nachteilen einer quantitativ unzuverlässigen Angabe des elektrischen Widerstands des Erdreiches.

Weiterer Stand der Technik findet sich in den Dokumenten DE102012019094, DE102016202021, DE102013209142 und EP3862763.

Der vorliegenden Erfindung liegt somit die Aufgabe zugrunde, ein Verfahren und eine Vorrichtung zur kontinuierlichen Überwachung eines Schutzleiterwiderstands einer Schutzleiterverbindung in einem Stromversorgungssystem vorzuschlagen, die keine zusätzliche Installation einer Pilot-, Steuer- oder Prüfleitung erfordern, die Ungenauigkeiten bei der Messwerterfassung vermeiden, eine zeitkontinuierliche Überwachung zulassen und für geerdete wie für ungeerdete Stromversorgungssysteme geeignet sind.

Bezogen auf eine Vorrichtung wird diese Aufgabe durch eine elektrische Messanordnung mit den im Anspruch 1 aufgeführten Merkmalen gelöst. Ausgangspunkt der Betrachtungen und somit Systemumgebungsvoraussetzungen zur Anwendung der Erfindung ist ein Stromversorgungssystem mit einer Versorgungsstation, welche erste Ableitkondensatoren, üblicherweise Filterkondensatoren zur Funkentstörung, aufweist, die zwischen jeweilige aktive Leiter einer Versorgungsleitung und der Schutzleiterverbindung geschaltet sind. Weiterhin wird von einer mit einer über die Schutzleiterverbindung geerdeten elektrischen Einrichtung ausgegangen, welche in gleicherweise zweite Ableitkondensatoren aufweist. Ein in der elektrischen Einrichtung angeordneter Verbraucher ist voraussetzungsgemäß über die aktiven Leiter der Versorgungsleitung mit der Versorgungsstation des Stromversorgungssystems verbunden. Erfindungsgemäß umfasst die Versorgungsstation einen Signalgenerator zur Erzeugung einer Signalwechselspannung mit einer bestimmten Messfrequenz. Um EMV-Störungen zu vermeiden ist die Signalwechselspannung vorzugsweise sinusförmig und wird bevorzugt über eine Digital-Analog-Umsetzung, gefolgt von einem Verstärker, von dem Signalgenerator bereitgestellt. Gesteuert wird der Signalgenerator von einer in einer Auswerteeinheit angeordneten digitalen Recheneinheit, die vorzugsweise als Mikrocontroller ausgeführt ist.

In der Versorgungsstation ist erfindungsgemäß ein erster Messstromwandler mit einer die Schutzleiterverbindung umschließenden ersten Wicklung zur induktiven Einkopplung der Signalwechselspannung in die Schutzleiterverbindung angeordnet. Damit ergibt sich über die ersten Ableitkondensatoren in der Versorgungsstation, die aktiven Leiter der Versorgungsleitung, die zweiten Ableitkondensatoren in der elektrischen Einrichtung und über die Schutzleiterverbindung eine Stromschleife, in der ein durch die eingeprägte Signalwechselspannung bewirkter Schleifenstrom fließt.

Da eine komplexwertige Schleifenimpedanzmessung auf Basis der an dem Schutzleiter gemessenen elektrischen Größen vorgenommen wird, weist der erste Messstromwandler eine ebenfalls die Schutzleiterverbindung umschließende zweite Wicklung zur Rückmessung einer Schutzleiterspannung auf.

Die elektrische Messanordnung umfasst weiterhin einen zweiten Messstromwandler mit einer Sekundärwicklung zur Erfassung eines in der Schutzleiterverbindung fließenden Schutzleiterstroms.

Eine Auswerteeinheit mit einer digitalen Recheneinheit dient in der elektrischen Messanordnung neben der Steuerung des Signalgenerators zur Bestimmung einer Schleifenimpedanz aus der Schutzleiterspannung und dem Schutzleiterstrom und zur Auswertung des Realteils der Schleifenimpedanz.

Die zugrundeliegende Idee der Erfindung besteht darin, dass bei hinreichend hoher Messfrequenz der eingekoppelten Signalwechselspannung die in der Versorgungsstation und in der elektrischen Einrichtung jeweils vorhandenen Ableitkondensatoren einen Schleifenstrom ermöglichen, der über die aktiven Leiter und die Schutzleiterverbindung fließt. Dadurch werden in erfindungsgemäßer Weise die aktiven Leiter der Versorgungsleitung in Funktion einer Pilotleitung verwendet. Die aktiven Leiter der Versorgungsleitung sind somit ein Teil der Schleife und ersetzen die aufwändige Installation einer Pilotleitung. Gleichwohl weisen die aktiven Leiter der Versorgungsleitung hinsichtlich der Bestimmung der Schleifenimpedanz dieselbe hohe Messgenauigkeit wie eine installierte Pilotleitung auf. Die erfindungsgemäße elektrische Messanordnung und das zugrunde liegende erfindungsgemäße Verfahren sind damit den bisher bekannten Verfahren, die auf einer Messstromrückleitung mittels parallel geschalteter Mehrfacherdungen beruhen, hinsichtlich der Messgenauigkeit überlegen.

Zudem ist die Erfindung unter den eingangs genannten Systemumgebungs-Voraussetzungen in geerdeten wie in ungeerdeten Stromversorgungssystemen einsetzbar, wobei die Messqualität einer Messanordnung mit Pilotleiter erreicht wird, ohne dass ein Pilotleiter tatsächlich vorhanden ist.

In vorteilhaferweise liegt die Messfrequenz (fs) der Signalwechselspannung (Us) in einem Bereich um 100 kHz.

Mit der Wahl dieser im Vergleich zu einer Netzfrequenz von beispielsweise 50 Hz vielfach höheren Messfrequenz von ca. 100 kHz wird die Störanfälligkeit gegenüber Verzerrungen der Netzspannung und nichtharmonischen Netzströmen stark reduziert, da die Messfrequenz in etwa bei der 2000. Harmonischen der Netzfrequenz liegt. Zudem nimmt der elektrische Widerstand der Ableitkondensatoren bei der gewählten Messfrequenz kleine Werte an, was zu einem hohen Schleifenstrom - der bis auf eine vernachlässigbare Abweichung dem gemessenen Schutzleiterstrom entspricht - und zu einem hohen Signal/Rauschabstand führt.

Weiterhin weist die elektrische Messanordnung eine Hochpass-Schaltung zur Filterung des Schutzleiterstroms auf. Die Hochpass-Schaltung ist vorzugsweise als analoges RC-Glied ausgeführt und trennt den erwünschten Schutzleiterstrom hoher Frequenz von Störeffekten niederer Frequenz.

Mit Vorteil weist die Auswerteeinheit Analog-Digital-Umsetzer zur Analog-Digitalen-Umsetzung der Schutzleiterspannung und des Schutzleiterstroms auf.

Vorzugsweise erfolgt die Weiterverarbeitung der gemessenen Schutzleiterspannung und des gemessenen Schutzleiterstroms nach Analog-Digital-Umsetzung mit Methoden der digitalen Signalverarbeitung.

Die beschriebene, erfindungsgemäße elektrische Messanordnung beruht auf der in dem unabhängigen Verfahrensanspruch beschriebenen technischen Lehre. Insoweit treffen auch die vorgenannten technischen Wirkungen und die daraus entstehenden Vorteile auf die Verfahrensmerkmale zu.

Insbesondere ist hervorzuheben, dass bei Verwendung von Messfrequenzen, die um ein vielfaches höher als die Netzfrequenz sind, die vorhandenen Ableitkondensatoren ebenso wie die aktiven Leiter der Versorgungsleitung neben der Schutzleiterverbindung einen Teil der Messschleife bilden. Indem also die aktiven Leiter der Versorgungsleitung wie eine Pilotleitung benutzt werden, kann auf eine tatsächliche Pilotleitung verzichtet werden, aber dennoch die Messgenauigkeit wie bei der Verwendung einer Pilotleitung erreicht werden.

Weitere vorteilhafte Ausgestaltungsmerkmale ergeben sich aus der nachfolgenden Beschreibungen und den Zeichnungen, die eine bevorzugte Ausführungsform der Erfindung anhand von Beispielen erläutern.

Es zeigen:
- **Fig. 1**: eine Messung der Schleifenimpedanz mit Pilotleiter nach dem Stand der Technik und
- **Fig. 2**: eine erfindungsgemäße elektrische Messanordnung.

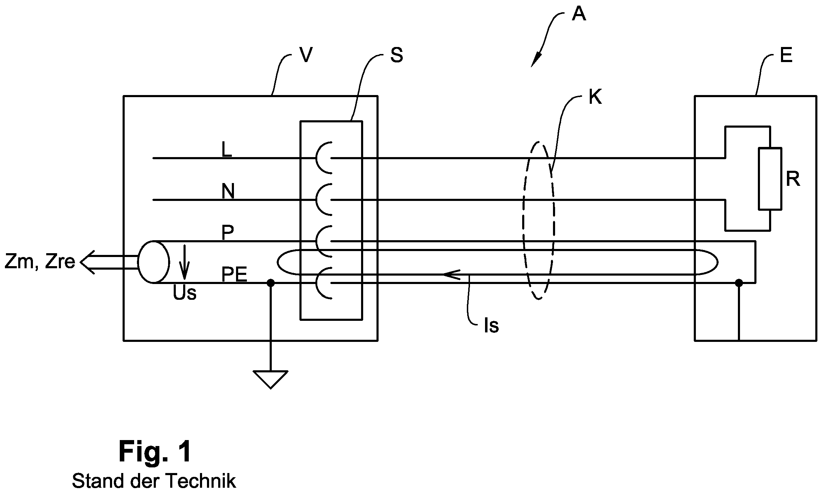

**Fig. 1** zeigt eine aus dem Stand der Technik bekannte Messung der Schleifenimpedanz Zm in einem TN-System A mit Pilotleiter P.

Eine Versorgungsstation V ist über eine Versorgungsleitung K mit der elektrischen Einrichtung E verbunden. Die Versorgungsleitung K weist neben den aktiven Leitern L und N und der Schutzleiterverbindung PE zusätzlich einen Pilotleiter P auf. Der Pilotleiter P ist in der elektrischen Einrichtung E mit der Schutzleiterverbindung PE verbunden, sodass sich eine Stromschleife ergibt, in der bei einer zwischen dem Pilotleiter P und der Schutzleiterverbindung PE in der Versorgungsstation V angelegten Signalwechselspannung Us ein Schleifenstrom Is fließt. Somit kann mit einer einfachen Widerstandsmessung in der Versorgungsstation V die Schleifenimpedanz Zm der Pilotleitung P und der Schutzleiterverbindung PE einschließlich der Kontaktwiderstände einer eventuell vorhandenen Steckverbindung S ermittelt werden.

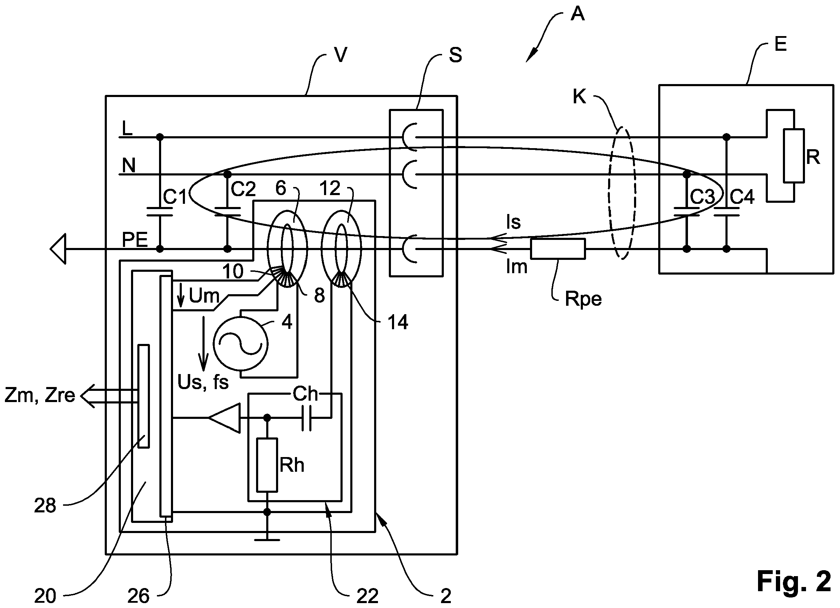

**Fig. 2** zeigt eine in der Versorgungsstation V befindliche erfindungsgemäße Messanordnung 2 in einem TN-System A. Die Versorgungsstation V ist über eine Versorgungsleitung K bestehend aus den aktiven Leitern L und N sowie der Schutzleiterverbindung PE und gegebenenfalls über eine Steckverbindung S mit einer elektrischen Einrichtung E verbunden, die einen Verbraucher R umfasst.

Sowohl die Versorgungsstation V als auch die elektrische Einrichtung E weisen jeweils von den aktiven Leitern L, N ausgehend zu der Schutzleiterverbindung PE erste Ableitkondensatoren C1, C2 bzw. zweite Ableitkondensatoren C3, C4 auf.

In dieser als vorgegeben betrachteten Systemumgebung ist die erfindungsgemäße elektrische Messanordnung 2 in der Verbraucherstation V angeordnet. Die elektrische Messanordnung 2 umfasst einen Signalgenerator 4 zur Erzeugung einer Signalwechselspannung Us mit einer Messfrequenz fs.

Die elektrische Messanordnung 2 weist weiter einen die Schutzleiterverbindung PE umschließenden ersten Messstromwandler 6 mit einer ersten Wicklung 8 zur induktiven Einkopplung der Wechselsignalspannung Us in die Schutzleiterverbindung PE auf. Der erste Messstromwandler 6 kann als Ringkern ausgeführt sein, durch den die Schutzleiterverbindung PE geführt wird.

Somit ergibt sich für einen Wechselstrom eine Stromschleife, die sich zusammensetzt aus: der Parallelschaltung der Ableitkondensatoren C1 und C2 in der Versorgungsstation V, der Parallelschaltung der aktiven Leiter L und N der Versorgungsleitung K - gegebenenfalls mit Kontaktwiderständen der Steckverbindung S, der Parallelschaltung der Ableitkondensatoren C3 und C4 in der elektrischen Einrichtung E und der Schutzleiterverbindung PE - gegebenenfalls mit dem entsprechenden Kontaktwiderstand der zugehörigen Steckverbindung S.

Der erste Messstromwandler 6 ist mit einer zweiten Wicklung 10 zur Rückmessung einer Schutzleiterspannung Um versehen. Die zweite Wicklung 10 ist hochohmig belastet und erzeugt die Schutzleiterspannung Um, die einem Analog-Digital-Umsetzer 26 zur Weiterverarbeitung in einer digitalen Recheneinheit 28 der Auswerteeinheit 20 zugeführt wird.

Die elektrische Messanordnung 2 umfasst weiter einen die Schutzleiterverbindung PE umschließenden zweiten Messstromwandler 12 mit einer Sekundärwicklung 14 zur Erfassung eines in der Schutzleiterverbindung PE fließenden Schutzleiterstroms Im. Der zweite Messstromwandler 12 wird als Stromtransformator betrieben, also in der Regel mit einem niederohmigen Abschluss versehen. Auch dieser zweite Messstromwandler 12 ist als Ringkern ausgeführt, durch den die Schutzleiterverbindung PE geführt wird.

Über eine analoge Hochpass-Schaltung 22, bestehend aus einem Kondensator Ch und einem ohmschen Widerstand Rh wird der von der Sekundärwicklung 14 erfasste Schutzleiterstrom Im über einen Verstärker der Auswerteeinheit 20 zugeführt. Die Grenzfrequenz der Hochpass-Schaltung 22 ist dabei so bemessen, dass die Netzfrequenz und gegebenenfalls auftretende Störkomponenten unterhalb der Messfrequenz fs hinreichend unterdrückt werden.

In der digitalen Recheneinheit 28 erfolgt die Bestimmung der Schleifenimpedanz Zm aus der Schutzleiterspannung Um und dem Schutzleiterstrom Im. Dabei erfolgt die Impedanzberechnung derart, dass Real- und Imaginärteil der Schleifenimpedanz Zm getrennt darstellbar sind. Vorzugsweise werden dazu nach der Analog-Digital-Umsetzung 26 in der digitalen Recheneinheit 28 numerische Verfahren der Berechnung von Fourierkoeffizienten angewendet.

Der Imaginärteil der so berechneten Schleifenimpedanz Zm entsteht nur durch die Wirkung der Ableitkondensatoren mit der rein imaginären Impedanz Zc=1/jωC. Der Realteil Zre der Schleifenimpedanz Zm der Stromschleife besteht aus folgenden Anteilen: dem äquivalenten Serienwiderstand (ESR) der Parallelschaltung der Ableitkondensatoren C1 und C2, dem ohmschen Widerstand der Parallelschaltung der aktiven Leiter L und N der Versorgungsleitung K - gegebenenfalls mit den Kontaktwiderständen der zugehörigen Steckverbindung S, dem äquivalenten Serienwiderstand (ESR) der Parallelschaltung der Ableitkondensatoren C3 und C4 und dem ohmschen Widerstand der Schutzleiterverbindung PE - gegebenenfalls mit dem zugehörigen Kontaktwiderstand.

Die ESR-Werte der Ableitkondensatoren sind meist so klein, dass sie vernachlässigt werden können. Man erkennt, dass der ohmsche Widerstand Rpe der Schutzleiterverbindung PE, gegebenenfalls mit dem zugehörigen Kontaktwiderstand, als Bestandteil der Messschleife nicht separat gemessen werden kann. Dies bedeutet aber kein Nachteil, da auch der ohmsche Widerstand der Parallelschaltung der aktiven Leiter L und N der Versorgungsleitung K stets einen vernachlässigbaren Wert ergibt. Somit entspricht der Realteil Zre der Schleifenimpedanz Zm in guter Näherung dem zu überwachenden Schutzleiterwiderstand Rpe. Bei einer Unterschreitung eines Schutzleiterwiderstands-Grenzwertes kann in geeigneter Weise, beispielsweise optisch und/oder akustisch, ein Warnhinweis signalisiert werden.

## Patentansprüche

1. Elektrische Messanordnung (2) zur kontinuierlichen Überwachung eines Schutzleiterwiderstands (Rpe) einer Schutzleiterverbindung (PE) in einem Stromversorgungssystem (A) mit einer Versorgungsstation (V), welche erste Ableitkondensatoren (C1, C2) aufweist, mit einer Versorgungsleitung (K), welche aktive Leiter (L, N) aufweist, und mit einer über die Schutzleiterverbindung (PE) geerdeten elektrischen Einrichtung (E), welche zweite Ableitkondensatoren (C3, C4) und einen Verbraucher (R) aufweist, umfassend einen Signalgenerator (4) zur Erzeugung einer Signalwechselspannung (Us) mit einer Messfrequenz (fs),
einen die Schutzleiterverbindung (PE) umschließenden ersten Messstromwandler (6) mit einer ersten Wicklung (8) zur induktiven Einkopplung der Signalwechselspannung (Us) in die Schutzleiterverbindung (PE), sodass ein Schleifenstrom (Is) über die ersten Ableitkondensatoren (C1, C2), die aktiven Leiter (L, N), die zweiten Ableitkondensatoren (C3, C4) und die Schutzleiterverbindung (PE) fließt, und mit einer zweiten Wicklung (10) zur Rückmessung einer Schutzleiterspannung (Um),
einen die Schutzleiterverbindung (PE) umschließenden zweiten Messstromwandler (12) mit einer Sekundärwicklung (14) zur Erfassung eines in der Schutzleiterverbindung (PE) fließenden Schutzleiterstromes (Im),
eine Auswerteeinheit (20) mit einer digitalen Recheneinheit (28) zur Steuerung des Signalgenerators (4), zur Bestimmung einer Schleifenimpedanz (Zm) aus der Schutzleiterspannung (Um) und dem Schutzleiterstrom (Im) und zur Auswertung des Realteils (Zre) der Schleifenimpedanz (Zm).

2. Elektrische Messanordnung (2) nach Anspruch 1,
**dadurch gekennzeichnet,**
**dass** die Messfrequenz (fs) der Signalwechselspannung (Us) in einem Bereich um 100 kHz liegt.

3. Elektrische Messanordnung (2) nach Anspruch 1 oder 2,
**gekennzeichnet durch**
eine Hochpass-Schaltung (22) zur Filterung des Schutzleiterstromes (Im).

4. Elektrische Messanordnung (2) nach einem der Ansprüche 1 bis 3, **dadurch gekennzeichnet,**
**dass** die Auswerteeinheit (20) Analog-Digital-Umsetzer (26) zur analog-digitalen Umsetzung der Schutzleiterspannung (Um) und des Schutzleiterstroms (Im) aufweist.

5. Verfahren zur kontinuierlichen Überwachung eines Schutzleiterwiderstands einer Schutzleiterverbindung (PE) in einem Stromversorgungssystem (A) mit einer Versorgungsstation (V), welche erste Ableitkondensatoren (C1, C2) aufweist, mit einer Versorgungsleitung (K), welche aktive Leiter (L, N) aufweist, und mit einer über die Schutzleiterverbindung (PE) geerdeten elektrischen Einrichtung (E), welche zweite Ableitkondensatoren (C3, C4) und einen Verbraucher (R) aufweist, umfassend die Verfahrensschritte:
Erzeugen einer Signalwechselspannung (Us) mit einer Messfrequenz (fs) mittels eines Signalgenerators (4),
induktives Einkoppeln der Signalwechselspannung (Us) in die Schutzleiterverbindung (PE) mittels eines die Schutzleiterverbindung (PE) umschließenden ersten Messstromwandlers (6) mit einer ersten Wicklung (8), sodass ein Schleifenstrom (Is) über die ersten Ableitkondensatoren (C1, C2), die aktiven Leiter (L, N) der Versorgungsleitung (K), die zweiten Ableitkondensatoren (C3, C4) und die Schutzleiterverbindung (PE) fließt,
Rückmessen einer Schutzleiterspannung (Um) mit einer zweiten Wicklung (10) des ersten Messstromwandlers (6),
Erfassen eines in der Schutzleiterverbindung (PE) fließenden Schutzleiterstromes (Im) mittels eines die Schutzleiterverbindung (PE) umschließenden zweiten Messstromwandlers (12) mit einer Sekundärwicklung (14) und
Steuern des Signalgenerators (4), Bestimmen einer Schleifenimpedanz (Zm) aus der Schutzleiterspannung (Um) und dem Schutzleiterstrom (Im) und Auswerten des Realteils (Zre) der Schleifenimpedanz (Zm) mittels einer digitalen Recheneinheit (28) in einer in der Versorgungsstation (V) angeordneten Auswerteeinheit (20).

6. Verfahren nach Anspruch 5,
**dadurch gekennzeichnet,**
**dass** die Messfrequenz (fs) in einem Bereich um 100 kHz liegt.

7. Verfahren nach Anspruch 5 oder 6,
**gekennzeichnet durch**
eine Filterung des Schutzleiterstromes (Im) mittels einer Hochpass-Schaltung (22).

8. Verfahren nach einem der Ansprüche 5 bis 7,
**gekennzeichnet durch**
eine analog-digitale Umsetzung (26) der Schutzleiterspannung (Um) und des Schutzleiterstroms (Im).

## Claims

1. An electric measuring assembly (2) for continuously monitoring a protective-conductor resistance (Rpe) of a protective-conductor connection (PE) in a power supply system (A) comprising a supply station (V), which comprises first leakage capacitors (C1, C2), comprising a supply line (K), which comprises active conductors (L, N), and comprising an electric installation (E), which is grounded via the protective-conductor connection (PE) and comprises second leakage capacitors (C3, C4) and a load (R), the electric measuring assembly (2) comprising
a signal generator (4) for generating a signal alternating voltage (Us) having a measuring frequency (fs),
a first measuring current transformer (6), which encircles the protective-conductor connection (PE) and has a first winding (8) for inductively coupling the signal alternating voltage (Us) into the protective-conductor connection (PE) so that a loop current (Is) flows via the first leakage capacitors (C1, C2), the active conductors (L, N), the second leakage capacitors (C3, C4) and the protective-conductor connection (PE), and has a second winding (10) for the return measurement of a protective-conductor voltage (Um),
a second measuring current transformer (12), which encircles the protective-conductor connection (PE) and has a secondary winding (14) for capturing a protective-conductor current (Im) flowing in the protective-conductor connection (PE),
an evaluation unit (20) having a digital computing unit (28) for controlling the signal generator (4), for determining a loop impedance (Zm) from the protective-conductor voltage (Um) and the protective-conductor current (Im) and for evaluating the real part (Zre) of the loop impedance (Zm).

2. The electric measuring assembly (2) according to claim 1,
**characterized in that**
the measuring frequency (fs) of the signal alternating voltage (Us) is in a range of approximately 100 kHz.

3. The electric measuring assembly (2) according to claim 1 or 2, **characterized by**
a high-pass circuit (22) for filtering the protective-conductor current (Im).

4. The electric measuring assembly (2) according to any one of the claims 1 to 3,
**characterized in that**
the evaluation unit (20) comprises analog-digital converters (26) for analog-digital conversion of the protective-conductor voltage (Um) and the protective-conductor current (Im).

5. A method for continuously monitoring a protective-conductor resistance of a protective-conductor connection (PE) in a power supply system (A) having a supply station (V), which comprises first leakage capacitors (C1, C2), comprising a supply line (K), which comprises active conductors (L, N), and comprising an electric installation (E), which is grounded via protective-conductor connection (PE) and comprises second leakage capacitors (C3, C4) and a load (R), the method comprising the following steps:
generating a signal alternating voltage (Us) having a measuring frequency (fs) by means of a signal generator (4),
inductively coupling the signal alternating voltage (Us) into the protective-conductor connection (PE) by means of a first measuring current transformer (6), which encircles the protective-conductor connection (PE) and has a first winding (8), so that a loop current (Is) flows via the first leakage capacitors (C1, C2), the active conductors (L, N) of the supply line (K), the second leakage capacitors (C3, C4) and the protective-conductor connection (PE),
conducting a second measurement of a protective-conductor voltage (Um) using a second winding (10) of the first measuring current transformer (6),
capturing a protective-conductor current (Im), which flows in the protective-conductor connection (PE), by means of a second measuring current transformer (12), which encircles the protective-conductor connection (PE) and has a secondary winding (14), and controlling the signal generator (4), determining a loop impedance (Zm) from the protective-conductor voltage (Um) and the protective-conductor current (Im), and evaluating the real part (Zre) of the loop impedance (Zm) by means of a digital computing unit (28) in an evaluation unit (20) disposed in the supply station (V).

6. The method according to claim 5,
**characterized in that**
the measuring frequency (fs) is in a range of approximately 100 kHz.

7. The method according to claim 5 or 6,
**characterized by**
filtering the protective-conductor current (Im) by means of a high-pass circuit (22).

8. The method according to any one of the claims 5 to 7,
**characterized by**
analog-digital conversion (26) of the protective-conductor voltage (Um) and the protective-conductor current (Im).

## Revendications

1. Disposition de mesure électrique (2) pour la surveillance continue d'une résistance (Rpe) du conducteur de protection d'une connexion (PE) du conducteur de protection dans un système (A) d'alimentation en courant comprenant une station d'alimentation (V), qui comprend des premiers condensateurs de fuite (C1, C2), comprenant une ligne d'alimentation (K), qui comprend des conducteurs actifs (L, N), et comprenant une installation électrique (E), qui est mise à la terre par la connexion (PE) du conducteur de protection et comprend des deuxièmes condensateurs de fuite (C3, C4) et un récepteur (R), la disposition de mesure électrique (2) comprenant
un générateur de signal (4) pour la génération d'une tension alternative de signal (Us) ayant une fréquence de mesure (fs),
un premier transformateur (6) de courant de mesure, qui encercle la connexion (PE) du conducteur de protection et a un premier enroulement (8) pour le couplage inductif de la tension alternative de signal (Us) dans la connexion (PE) du conducteur de protection de sorte qu'un courant de bouclage (Is) s'écoule par les premiers condensateurs de fuite (C1, C2), par les conducteurs actifs (L, N), par les deuxièmes condensateurs de fuite (C3, C4) et par la connexion (PE) du conducteur de protection, et a un deuxième enroulement (10) pour la mesure de retour d'une tension (Um) du conducteur de protection,
un deuxième transformateur (12) de courant de mesure, qui encercle la connexion (PE) du conducteur de protection et a un enroulement secondaire (14) pour capturer un courant (Im) du conducteur de protection s'écoulant dans la connexion (PE) du conducteur de protection,
une unité d'évaluation (20) ayant une unité de compte (28) numérique pour le contrôle du générateur de signal (4), pour la détermination d'une impédance de bouclage (Zm) à partir de la tension (Um) du conducteur de protection et du courant (Im) du conducteur de protection et pour l'évaluation de la partie réelle (Zre) de l'impédance de bouclage (Zm).

2. Disposition de mesure électrique (2) selon la revendication 1,
**caractérisée en ce que**
la fréquence de mesure (fs) de la tension alternative de signal (Us) se trouve dans une plage d'environ 100 kHz.

3. Disposition de mesure électrique (2) selon la revendication 1 ou la revendication 2,
**caractérisée par**
un circuit de filtre passe-haut (22) pour le filtrage du courant (Im) du conducteur de protection.

4. Disposition de mesure électrique (2) selon l'une quelconque des revendications 1 à 3,
**caractérisée en ce que**
l'unité d'évaluation (20) comprend des convertisseurs analogique-numérique (26) pour la conversion analogique-numérique de la tension (Um) du conducteur de protection et du courant (Im) du conducteur de protection.

5. Procédé pour la surveillance continue d'une résistance de conducteur de protection d'une connexion (PE) du conducteur de protection dans un système (A) d'alimentation en courant ayant une station d'alimentation (V), qui comprend des premiers condensateurs de fuite (C1, C2), comprenant une ligne d'alimentation (K), qui comprend conducteurs actifs (L, N), et comprenant une installation électrique (E), qui est mise à la terre par la connexion (PE) du conducteur de protection et comprend des deuxièmes condensateurs de fuite (C3, C4) et un récepteur (R), le procédé comprenant les étapes suivantes :
générer une tension alternative de signal (Us) ayant une fréquence de mesure (fs) au moyen d'un générateur de signal (4),
coupler de manière inductive la tension alternative de signal (Us) dans la connexion (PE) du conducteur de protection au moyen d'un premier transformateur (6) de courant de mesure, qui encercle la connexion (PE) du conducteur de protection et a un premier enroulement (8), de sorte qu'un courant de bouclage (Is) s'écoule par les premiers condensateurs de fuite (C1, C2), par les conducteurs actifs (L, N) de la ligne d'alimentation (K), par les deuxièmes condensateurs de fuite (C3, C4) et par la connexion (PE) du conducteur de protection,
conduite une mesure de retour d'une tension (Um) du conducteur de protection en utilisant un deuxième enroulement (10) du premier transformateur (6) de courant de mesure,
capturer un courant (Im) du conducteur de protection, qui s'écoule dans la connexion (PE) du conducteur de protection, au moyen d'un deuxième transformateur (12) de courant de mesure, qui encercle la connexion (PE) du conducteur de protection et a un enroulement secondaire (14), et
contrôler le générateur de signal (4), déterminer une impédance de bouclage (Zm) à partir de la tension (Um) du conducteur de protection et du courant (Im) du conducteur de protection et évaluer la partie réelle (Zre) de l'impédance de bouclage (Zm) au moyen d'une unité de compte (28) numérique dans une unité d'évaluation (20) disposée dans la station d'alimentation (V).

6. Procédé selon la revendication 5,
**caractérisée en ce que**
la fréquence de mesure (fs) se trouve dans une plage d'environ 100 kHz.

7. Procédé selon la revendication 5 ou la revendication 6,
**caractérisée par**
le filtrage du courant (Im) du conducteur de protection au moyen d'un circuit de filtre passe-haut (22).

8. Procédé selon l'une quelconque des revendications 5 à 7,
**caractérisée par**
une conversion analogique-numérique (26) de la tension (Um) du conducteur de protection et du courant (Im) du conducteur de protection.
